Europäisches Patentamt

(19) European Patent Office

Office européen des brevets

(11) EP 0 917 184 A2

(12) EUROPEAN PATENT APPLICATION

(43) Date of publication:
19.05.1999 Bulletin 1999/20

(51) Int. Cl.⁶: **H01L 21/316**

(21) Application number: 98304291.2

(22) Date of filing: 01.06.1998

(84) Designated Contracting States:
AT BE CH CY DE DK ES FI FR GB GR IE IT LI LU MC NL PT SE
Designated Extension States:
AL LT LV MK RO SI

(30) Priority: 31.10.1997 US 962500

(71) Applicant:
DOW CORNING CORPORATION
Midland Michigan 48686-0994 (US)

(72) Inventors:
• Chung, Kyuha
North Midland, Michigan 48642 (US)
• Saha, Chandan Kumar
West Bloomfield, Michigan 48324 (US)
• Liou, Huey-Chiang
Midland, Michigan 48640 (US)
• Liu. Youfan
Midland, Michigan 48640 (US)

(74) Representative: Hall, Marina
Elkington and Fife
Prospect House,
8 Pembroke Road
Sevenoaks, Kent TN13 1XR (GB)

(54) **Electronic coatings having low dielectric constant**

(57) This invention is a method for producing insoluble coatings having a dielectric constant (Dk) of 2.5 to 2.8 on electronic substrates. The method comprises applying a composition comprising hydrogen silsesquioxane resin onto a substrate to form a film on the substrate; and heating the substrate at a temperature of 200°C. to 550°C. wherein the substrate is heated at a rate and for a time sufficient to produce an insoluble coating having a dielectric constant of 2.5 to 2.8.

EP 0 917 184 A2

## Description

This invention is a method for making a hydrogen silsesquioxane resin (H-resin) coating having a dielectric constant (Dk) of less than 2.9, preferably of 2.5-2.8. These coatings are useful in the manufacture of semiconductor devices as interlayer dielectric coatings.

The use of H-resin as a spin on material that is subsequently cured for use as an interlayer dielectric coating is known in the art. Under known thermal processing and cure conditions (i.e., 1 minute hold at each of the three serial hot plates followed by 1 hour in a furnace with a nitrogen atmosphere) Dks of 2.9-3.0 are achieved.

Cured materials having a Dk of 2.9-3.0 are suitable for 0.25 micrometer and larger devices. However, lower dielectric constants are required for smaller device structures (i.e. 0.13-0.18 micrometer). Several methods have been proposed for curing H-resin to produce lower dielectric constants. However, these methods often require difficult and expensive processing to produce low Dk coatings. For example, U.S. Patent 5,441,765 discloses a method for producing coatings from H-resin wherein the cured coating has a Dk of 2.8 to 4.5. The process disclosed in '765 comprises applying the H-resin onto the device; heating the coated device for time sufficient to produce an Si-O containing ceramic coating and thereafter exposing the Si-O containing ceramic coating to an annealing atmosphere containing hydrogen gas.

U.S. Patent 5,547,703 also claims a method for producing low Dk coatings. The method comprises applying H-resin on the electronic substrate; heating in ammonia and moisture; thereafter heating in anhydrous ammonia and finally heating in oxygen to anneal the coating. The Dk of the coatings produced by this method are reported to be between 2.42 and 4.92.

It has now been found that when H-resin is cured under controlled conditions (heating rate, temperature, time and environment) that coatings having low dielectric constant are conveniently produced.

It is therefore an object of the instant invention to provide a process for producing insoluble coatings from H-resin which have a dielectric constant of 2.5 to 2.8.

Our method used to produce these low Dk coatings comprising (A) applying a composition comprising H-resin onto a substrate to form a film on the substrate; and (B) heating the substrate at a temperature of 200°C. to 550°C. wherein the substrate is heated at a rate and for a time sufficient to produce an insoluble coating having a Dk of 2.5 to 2.8. Dielectric Constant (Dk) as used herein is the dielectric constant at 1 MHz.

The H-resin useful herein include hydridosiloxane resins consisting of units of the formula $HSi(OH)_x(OR)_yO_{z/2}$, in which each R is independently an organic group or a substituted organic group which, when bonded to silicon through the oxygen atom, forms a hydrolyzable substituent; $x = 0$ to 2; $y = 0$ to 2; $z = 1$ to 3; and $x + y + z = 3$. Examples of R include alkyls such as methyl, ethyl, propyl and butyl; aryls such as phenyl; and alkenyls such as allyl or vinyl. These resins may be essentially fully condensed, $(HSiO_{3/2})_n$ where n is 8 or greater or they may be only partially hydrolyzed (i.e., containing some Si-OR) and/or partially condensed (i.e., containing some Si-OH). Although not represented by the structure, these resins may also contain a small number (e.g. less than 10%) of the silicon atoms which have either 0 or 2 hydrogen atoms attached thereto or a small number of SiC bonds due to various factors involved in their formation or handling.

The structure of the H-resin is not specifically limited and may be what is generally known as ladder-type, cage-type or mixtures thereof. The above hydrogen silsesquioxane resins and methods for their production are known in the art. For example, U.S. Patent 3,615,272 shows the production of an essentially fully condensed H-resin (which may contain up to 100-300 ppm silanol) by a process comprising hydrolyzing trichlorosilane in a benzenesulfonic acid hydrate hydrolysis medium and then by washing the resultant resin with water or aqueous sulfuric acid. Similarly, U.S. Patent 5,010,159 describes a method comprising hydrolyzing hydridosilanes in an arylsulfonic acid hydrate hydrolysis medium to form a resin which is thereafter contacted with a neutralizing agent.

Other hydridosiloxane resins, such as those described by U.S. Patents 4,999,397 and 5,210,160, those produced by hydrolyzing an alkoxy or acyloxy silane in an acidic, alcoholic hydrolysis medium; those described in JP-As 59-178749, 60-86017 and 63-107122; or any other equivalent hydridosiloxane, will also suitably function herein.

In a preferred embodiment of our invention, specific molecular weight fractions of the above H-resins may also be used. Such fractions and methods for their preparation are taught in U.S. Patents 5,063,267 and 5,416,190. A preferred fraction comprises material wherein at least 75% of the polymeric species have a number average molecular weight of 1200 or greater and a more preferred fraction comprises material wherein at least 75% of the polymeric species have a number average molecular weight between 1200 and 100,000.

Our H-resin may also contain other components so long as these components do not interfere with the integrity of the coating or increase the dielectric constant of the ultimate coating. Known additives include catalysts such as platinum, rhodium or copper catalyst which increase the rate and/or extent of cure of said resin as described in U.S. Patent 4,822,697. Ceramic oxide precursors may also be used in combination with the H-resin. The ceramic oxide precursors useful herein include compounds of various metals such as aluminum, titanium, zirconium, tantalum, niobium and/or vanadium as well as various non-metallic compounds, such as those of boron or phosphorous which may be dissolved in solution, hydrolyzed and subsequently pyrolyzed at relatively low temperature to form ceramic oxides. Ceramic oxide precursors useful herein are further described and derived from U.S. Patents 4,808,653, 5,008,320 and 5,290,394.

The H-resin is typically applied to the substrate as a solvent dispersion. Suitable solvents include any agent or mixture of agents which will dissolve the said resin to form a homogeneous liquid mixture without affecting the resulting coating. These solvents include alcohols such as ethyl alcohol or isopropyl alcohol; aromatic hydrocarbons such as benzene or toluene; alkanes such as n-heptane, dodecane or nonane; ketones such as methyl isobutyl ketone; esters; glycol ethers and siloxanes such as linear dimethylpolysiloxanes (e.g. hexamethyldisiloxane, octamethyldisiloxane and mixtures thereof) or cyclic dimethylpolysiloxanes. The solvent is present in an amount sufficient to dissolve the H-resin to the concentration desired for application. Typically, the solvent is present in an amount of 20 to 99 wt%, preferably from 50 to 95 wt%, based on the total weight of said resin and solvent.

Specific methods for application of the H-resin include spin coating, dip coating, spray coating, flow coating, screen printing and the like. The preferred method for application is spin coating. When a solvent is used, the solvent is allowed to evaporate from the coated substrate resulting in the deposition of an H-resin film on the substrate. Any suitable means for evaporation may be used such as simple air drying by exposure to an ambient environment, the application of a vacuum or mild heat (<200°C.) during the early stages of the curing process. It should be noted that when spin coating is used, the additional drying method is minimized as the spinning drives off solvent.

Following application to the substrate, the H-resin is cured to an insoluble coating having a Dk of 2.5 to 2.8 by heating at a temperature of 200°C. to 550°C. at a rate and for a time sufficient to produce an insoluble coating. By "insoluble coating", it is meant a coating that is essentially not soluble in the solvent from which the H-resin is deposited to form said film or any solvent delineated above as being useful herein for the application of the H-resin. Preferably, the coatings are heated at a temperature of 150°C. to 500°C. When the coatings have a thickness of approximately 1.5 to 2.5 micrometers, it is most preferable to heat at a temperature of 200°C. to 400°C. When the coatings have a thickness of less than 1.5 micrometers, it is most preferable to heat a temperature of 280°C. to 380°C.

Any method of heating such as the use of convection oven, rapid thermal processing, hot plate and radiant or microwave energy may be used herein. The method used must be capable of heating the substrate to the desired temperature at a rate sufficient to produce the insoluble coating having a Dk of 2.5 to 2.8.

The rate at which the H-resin coated substrate is heated to the curing temperature (i.e., ramp up rate) is critical to achieving an insoluble coating having a Dk of 2.5 to 2.8. For example, if the resin coated substrate is heated too slowly to the desired temperature, then the coating of this invention will not be obtained. Because numerous factors such as substrate size, gas flow rates, coating thickness and the heating means will all effect the heating rate, it is not possible to specify a quantified heating rate. But, said rate for our coatings are usually higher than 20°C./min.

One skilled in the art will be able to determine the appropriate heating rate based on the conditions and means used to heat the H-resin coated substrate. For example, it has been found that thinner coatings need to be heated to the desired temperature at a faster rate than thicker coatings. Larger substrates require higher set temperatures to maintain the same heating rates as smaller substrates. Flow of hotter nitrogen helps increase heating rate and reduces the Dk of the coating.

The duration of time that the coating is heated to cure will depend on the environment during the heating, the temperature to which it is heated (i.e. soak temperature), the rate at which it is heated and the thickness of the H-resin film. At higher soak temperatures and/or higher concentrations of oxygen in the cure environment, the cure time will be shorter. Typically, the coating is heated for 1 second to 2 hours, preferably from 5 seconds to 30 minutes.

The environment in which the H-resin coated substrate is heated is normally an inert environment such as nitrogen, argon and helium or an environment containing oxygen such as air. Oxygen regardless of its source such as air, peroxides, ozone etc. is preferably present in the environment when the H-resin coated substrate is cured at temperatures below 450°C.

Preferably, the H-resin coated substrate is heated in an environment containing nitrogen at a temperature of between 280°C. and 500°C. to produce the insoluble coating having a Dk of 2.5 to 2.8. The dielectric constant of the converted coating was determined by performing Dk measurements on metal-insulator-semiconductor (MIS) capacitors. MIS capacitors were formed by depositing aluminum electrodes of 0.15 $\mu$m onto low resistivity ($\rho \leq 0.025\Omega$ cm) silicon wafers coated with a thin film of insoluble coating. A shadow mask was utilized to form aluminum electrode dots of diameter ranging from 3 to 10 mm. Impedance measurements were made across electrode dots of the same diameter over a frequency range of 0.1 - 1000 kHz using a Hewlett-Packard™ 4194A Impedance Analyzer. The impedance data was fit to a series RLC model from which the equivalent parallel capacitance and Dk were calculated. Since impedance was characterized across the surface dot electrodes, twice the dielectric thickness was used for Dk measurements.

It is theorized that the H-resin, when heated at a sufficient rate and for a sufficient period of time, undergoes a volume expansion during the cure without a detrimental chemical change. This free volume, unexpectedly created in the cured coating gives rise to a reduction in Dk. As explained herein, the expansion of the coating is influenced by the cure temperature, time, rate of heating and the environment in which said resin is cured.

The insoluble coatings produced herein have a Dk of 2.5 to 2.8, preferably 2.5 to 2.75, and more preferably 2.5 to 2.7.

The insoluble coatings produced herein may be produced on any substrate. However, the coatings are particularly useful on electronic substrates. By "electronic substrate", it is meant to include silicon based devices and gallium arsenide based devices intended for use in the manufacture of a semiconductor component including focal plane arrays, opto-electronic devices, photovoltaic cells, optical devices, transistor-like devices, 3-D devices, silicon-on-insulator devices and super lattice devices.

The electronic substrates can be bare (i.e. no passivation) or the substrate can have primary passivation. Such primary passivation can be ceramic coatings such as silica, silicon nitride, silicon carbide, silicon oxynitride, silicon oxycarbide, PSG, BPSG and others. Primary passivation coatings and methods for producing them are known to those skilled in the art.

The coatings produced herein may be applied to a wafer prior to the application of any metallization. The coatings may also be applied over metallization as an interlevel or interlayer dielectric or the coatings may be applied as a top passivation coating to complete the formation of the device.

Additional coatings may then be applied over the insoluble coating if desired. These can include, for example, $SiO_2$ coatings, silicon containing coatings, silicon carbon containing coatings, silicon nitrogen containing coatings, silicon oxygen nitrogen containing coatings, silicon nitrogen carbon containing coatings and/or diamond like coatings produced from deposition (i.e. CVD, PECVD, etc.) of amorphous SiC:H, diamond and silicon nitride. Methods for the application of such coatings are known in the art and are more fully described, for example, in U.S. Patents 4,756,977 and 5,011,706.

The method of applying an additional coating is not critical and such coatings are applied by any chemical vapor deposition technique such as thermal chemical vapor deposition (TCVD), photochemical vapor deposition, plasma enhanced chemical vapor deposition (PECVD), electron cyclotron resonance (ECR) and jet vapor deposition. It is also feasible to be applied by physical vapor deposition techniques such as sputtering or electron beam evaporation. These processes involve either the addition of energy in the form of heat or plasma to a vaporized species to cause the desired reaction or they focus energy on a solid sample of the material to cause its deposition. The method for applying the additional coating is not critical.

So that those skilled in the art can better understand and appreciate the invention taught herein, the following examples are presented.

In the following examples Refractive Index (RI) was measured using a AXIC Tyger™ thin film analyzer.

EXAMPLE 1

A hydrogen silsesquioxane resin (H-resin) composition comprising 18 wt% H-resin $(HSiO_{3/2})_n$ was prepared according to U.S. Patent 3,615,272 having a number average molecular weight of between 9,800 and 13,900. Said resin was dissolved in methyl iso-butyl ketone and coated on 10.2 cm (four inch) diameter sample wafers using a Headway™ spin coater at 2000 rpm for 20 seconds.

For curing coatings on the wafers, an environmental control dual chamber oven was used. The oven was capable of purging the chambers with inert gas (nitrogen) and keeping the environment in low oxygen concentration. The chamber where the wafers were loaded and unloaded was kept at a much lower temperature (< 200°C.) than that of the other chamber divided by a metal partition. The high temperature chamber was preheated to the cure temperature. The incoming nitrogen to the high temperature chamber was preheated at the cure temperature while no preheating was done for the nitrogen in the low temperature chamber. The spun coated wafer was loaded into the low temperature chamber and then both chambers were purged with nitrogen flow. As the oxygen concentration reached the 0.5% level (typically took 30 - 40 seconds after closing the door), the wafer was transferred to the next high temperature cure chamber. The wafer was left in the cure chamber for 2 minutes while the oxygen concentration continuously monitored showed less than 0.1%. The wafer was moved back to the loading/unloading chamber and cooled down to below 200°C. before being taken out to the air.

The H-resin coatings on the wafers were heated at varying temperatures (see Table 1). All coatings on the wafers were cured for 2 minutes (total time including heat up time). Results are given in Table 1. It is believed that the coatings cured at the lower temperatures (350°C. to 390°C.) did not produce low Dk coatings because the heating rate was inadequate.

Table 1

| Results of nitrogen cure of hydrogen silsesquioxane resin coated wafers. | | | | |
|---|---|---|---|---|
| Wafer # | Temperature (°C.) | Thickness (Å) | RI | Dk (Measured) |
| 1 | 350 | 4596 | 1.386 | -- |
| 2 | 350 | 4682 | 1.394 | -- |
| 3 | 360 | 4759 | 1.394 | -- |
| 4 | 360 | 4657 | 1.391 | -- |
| 5 | 370 | 4669 | 1.386 | -- |
| 6 | 370 | 4683 | 1.388 | -- |
| 7 | 380 | 4676 | 1.385 | -- |
| 8 | 380 | 4706 | 1.385 | -- |
| 9 | 390 | 4715 | 1.373 | -- |
| 10 | 390 | 4720 | 1.385 | -- |
| 11 | 400 | 4719 | 1.370 | 2.81 |
| 12 | 400 | 4606 | 1.375 | 2.76 |
| 13 | 410 | 4662 | 1.369 | 2.67 |
| 14 | 410 | 4645 | 1.371 | 2.72 |
| 15 | 420 | 4657 | 1.366 | 2.69 |
| 16 | 420 | 4764 | 1.373 | 2.69 |
| 17 | 430 | 4821 | 1.355 | 2.69 |
| 18 | 430 | 4884 | 1.351 | 2.70 |
| 19 | 440 | 4885 | 1.352 | 2.65 |
| 20 | 440 | 4891 | 1.357 | 2.69 |
| 21 | 450 | 4971 | 1.354 | 2.60 |
| 22 | 450 | 4877 | 1.363 | 2.59 |
| 23 | 460 | 4987 | 1.354 | 2.60 |
| 24 | 460 | 5059 | 1.353 | 2.68 |
| 25 | 470 | 4905 | 1.358 | 2.63 |
| 26 | 470 | 4823 | 1.368 | 2.55 |
| 27 | 480 | 4965 | 1.352 | 2.59 |
| 28 | 480 | 4969 | 1.347 | 2.61 |
| 29 | 490 | 4843 | 1.348 | 2.64 |
| 30 | 490 | 4979 | 1.351 | 2.67 |
| 1Å = 0.1 nm | | | | |

EXAMPLE 2

An H-resin composition comprising 40 wt% H-resin $(HSiO_{3/2})_n$ was prepared according to U.S. Patent 3,615,272 and having a number average molecular weight of between 9,800 and 13,900, was dissolved in low viscosity polydimethylsiloxanes (30 parts hexamethyldisiloxane:70 parts octamethyltrisiloxane) and was coated onto 10.2 cm (4") diameter wafers. All wafers having a 1.6 μm coating were produced using a Headway™ spin coater at 3000 rpm for 40 seconds. All wafers having a 2.2 μm coating were produced using a Headway™ spin coater at 2000 rpm for 40 seconds.

The H-resin coatings on wafers prepared as described above were then cured on a hot plate in an air environment at varying temperatures (see Table 2). Results are given in Table 2.

The relationship between Dk at 1 MHz and refractive index (RI) at 632.8 nm, for H-resin coatings was constructed as follows: $Dk = 1 + 4.43(RI - 1) + 0.95(RI - 1)^2$. Therefore, by measuring refractive index, dielectric constant can be easily predicted.

Table 2

| Results of air cure of hydrogen silsesquioxane resin coated wafers. | | | | | |
|---|---|---|---|---|---|
| Wafer # | Temp (°C.) | Thickness (Å) | Cure Time (min) | RI | Dk (Predicted) |
| 1 | 230 | 22703 | 1 | 1.410 | 2.98 |
| 2 | 230 | 21575 | 2 | 1.411 | 2.98 |
| 3 | 230 | 23828 | 4 | 1.396 | 2.90 |
| 4 | 250 | 22395 | 1 | 1.400 | 2.92 |
| 5 | 250 | 22752 | 2 | 1.340 | 2.62 |
| 6 | 250 | 23465 | 4 | 1.360 | 2.72 |
| 7 | 270 | 22170 | 1 | 1.312 | 2.47 |
| 8 | 270 | 23130 | 2 | 1.320 | 2.51 |
| 9 | 270 | 23430 | 4 | 1.303 | 2.43 |
| 10 | 290 | 22760 | 1 | 1.337 | 2.60 |
| 11 | 290 | 23670 | 2 | 1.305 | 2.44 |
| 12 | 230 | 16032 | 1 | 1.326 | 2.55 |
| 13 | 230 | 16150 | 2 | 1.342 | 2.63 |
| 14 | 230 | 14764 | 4 | 1.359 | 2.71 |
| 15 | 250 | 16058 | 1 | 1.307 | 2.45 |
| 16 | 250 | 16106 | 2 | 1.300 | 2.41 |
| 17 | 250 | 16033 | 4 | 1.305 | 2.44 |
| 18 | 270 | 16579 | 1 | 1.321 | 2.52 |
| 19 | 270 | 16569 | 2 | 1.317 | 2.50 |
| 20 | 270 | 16411 | 4 | 1.297 | 2.40 |
| 21 | 290 | 16662 | 1 | 1.301 | 2.42 |
| 22 | 290 | 16609 | 2 | 1.303 | 2.43 |
| 23 | 290 | 16374 | 4 | 1.302 | 2.42 |
| 24 | 310 | 16523 | 1 | 1.296 | 2.39 |
| 25 | 310 | 16676 | 2 | 1.302 | 2.42 |
| 26 | 310 | 16712 | 4 | 1.294 | 2.38 |
| 27 | 330 | 16539 | 1 | 1.305 | 2.44 |
| 28 | 330 | 16604 | 2 | 1.293 | 2.38 |
| 29 | 330 | 16412 | 4 | 1.289 | 2.36 |
| 1Å = 0.1 nm | | | | | |

EXAMPLE 3

In this example, two H-resin coatings on wafers were prepared according to the method of Example 1. The first coating was cured in a furnace while the second coating was cured on a hot plate. Both coatings were cured in a nitrogen environment at 350°C. for 30 minutes. Results are given in Table 3.

Table 3

| Results of comparison of coating thickness. | | | | |
|---|---|---|---|---|
| | Thickness | RI | Dk (Measured) | Heating Rate |
| Furnace Cure | 5222 Å | 1.381 | 2.87 | ~20 °C/min |
| Hot Plate Cure | 7523 Å | 1.360 | 2.72 | ~20 °C/sec |
| 1Å = 0.1 nm | | | | |

EXAMPLE 4

This Example demonstrates the effect of wafer size on the cure and Dk. As seen from the results, larger wafers need higher set temperature to obtain the same heating rate as that of the smaller wafers at lower set temperature.

| Wafer size | Cured in a oven with nitrogen flow. | Thickness (Å) | RI | DK (Predicted) |
|---|---|---|---|---|
| 4" | 450°C. for 2min | 5649 | 1.348 | 2.66 |
| 4" | 460°C. for 2min | 6444 | 1.343 | 2.63 |
| 8" | 460°C. for 2min | 4901 | 1.385 | 2.85 |
| 8" | 490°C. for 2min | 7064 | 1.346 | 2.65 |
| 1" = 2.54 cm<br>1Å = 0.1 nm | | | | |

EXAMPLE 5

This example demonstrates the effect of hot nitrogen flow on the cure and Dk.

| Wafer ID | Cured in an oven with nitrogen flow. | Thickness (Å) | RI | DK (Predicted) |
|---|---|---|---|---|
| w1 | 450°C. for 2min with nitrogen flow @350°C. | 4862 | 1.348 | 2.66 |
| w2 | 450°C. for 2 min with nitrogen flow @300°C. | 4903 | 1.351 | 2.67 |
| 1Å = 0.1 nm | | | | |

Claims

1.  A method of producing a coating comprising applying a composition comprising hydrogen silsesquioxane resin onto a substrate to form a film on said substrate and thereafter heating the film at a temperature of 200°C. to 550°C. at a rate and for a time sufficient to produce an insoluble coating having a dielectric constant of 2.5 to 2.8.

2.  The method of claim 1 wherein the film is heated for a period of 1 second to 2 hours.

3.  The method of claim 1 wherein the film is heated at a rate of at least 20°C./min.

4. The method of any of claims 1 to 3 wherein the film has a thickness of 1.5 to 2.5 micrometers and is heated at a temperature of 200°C. to 500°C.

5. The method of any of claims 1 to 4 wherein the film is heated on a hot plate.

6. The method of any of claims 1 to 4 wherein the film is heated in an oven.

7. The method of any of claims 1 to 4 wherein the film is heated in an inert environment.

8. The method of any of claims 1 to 4 wherein the film is heated in an oxygen containing environment.

9. The method of any of claims 1 to 8 wherein the hydrogen silsesquioxane resin is a hydridosiloxane resin consisting of units of the formula $HSi(OH)_x(OR)_yO_{z/2}$, in which each R is independently an organic group or a substituted organic group which, when bonded to silicon through the oxygen atom, forms a hydrolyzable substituent; $x = 0$ to 2; $y = 0$ to 2; $z = 1$ to 3 and $x + y + z = 3$ .

10. The method of any of claims 1 to 8 wherein the hydrogen silsesquioxane resin has the formula $(HSiO_{3/2})n$ wherein n is 8 or greater.

11. The method of any of claims 1 to 10 wherein the composition also contains a solvent.

12. The method of any of claims 1 to 10 wherein the composition also contains a solvent and most of the solvent is removed after the composition has been applied to the substrate and prior to heating.

13. The method of claims 11 wherein the composition contains from 50 to 95 wt% based on the total weight of hydrogen silsesquioxane resin and solvent.

14. The method of any of claims 1 to 13 wherein the composition is applied by spin coating.

15. The method of any of claims 1 to 14 wherein the substrate is an electronic substrate.

16. The method of claims 15 wherein the substrate is an electronic substrate having a primary passivation coating thereon.

17. The method of any of claims 1 to 16 wherein there is applied over the insoluble coating at least one additional coating selected from the group consisting of $SiO_2$ coatings, silicon containing coatings, silicon carbon containing coatings, silicon nitrogen containing coatings, silicon oxygen nitrogen containing coatings, silicon nitrogen carbon containing coatings and/or diamond like coatings.